(19) Europäisches Patentamt
European Patent Office
Office européen des brevets

(11) **EP 1 601 624 B1**

(12) **FASCICULE DE BREVET EUROPEEN**

(45) Date de publication et mention
de la délivrance du brevet:
**07.03.2007 Bulletin 2007/10**

(21) Numéro de dépôt: **04718986.5**

(22) Date de dépôt: **10.03.2004**

(51) Int Cl.:
**C03C 13/00** (2006.01)

(86) Numéro de dépôt international:
**PCT/FR2004/000568**

(87) Numéro de publication internationale:
**WO 2004/083142 (30.09.2004 Gazette 2004/40)**

(54) **FILS DE VERRE APTES A RENFORCER DES MATIERES ORGANIQUES ET/OU INORGANIQUES, PROCEDE DE FABRICATION DESDITS FILS ET COMPOSITION UTILISEE**

BEWEHRUNGSGLASFASER FÜR ORGANISCHE SOWOHL ALS AUCH ANORGANISCHE MATERIALIEN, VERFAHREN ZUR HERSTELLUNG DESSEN UND VERWENDETE ZUSAMMENSETZUNG

GLASS FIBRE FOR THE REINFORCEMENT OF ORGANIC AND/OR INORGANIC MATERIALS, METHOD FOR PRODUCTION OF SAID GLASS FIBRES AND CORRESPONDING COMPOSITION

(84) Etats contractants désignés:
**AT BE BG CH CY CZ DE DK EE ES FI FR GB GR HU IE IT LI LU MC NL PL PT RO SE SI SK TR**
Etats d'extension désignés:
**LT**

(30) Priorité: **13.03.2003 FR 0303206**

(43) Date de publication de la demande:
**07.12.2005 Bulletin 2005/49**

(73) Titulaire: **Saint-Gobain Vetrotex France S.A.**
**73000 Chambéry (FR)**

(72) Inventeurs:
• **CREUX, Sophie**
**NL-2622 HT DELFT (NL)**
• **LECOMTE, Emmanuel**
**F-93000 Bobigny (FR)**
• **RENAUD, Nicolas**
**F-73000 Barberaz (FR)**

(74) Mandataire: **Jamet, Vincent**
**Saint-Gobain Recherche,**
**39, quai Lucien Lefranc**
**93300 Aubervilliers (FR)**

(56) Documents cités:
**EP-A- 0 498 425**    **EP-A- 1 086 930**
**FR-A- 2 825 084**

## Description

La présente invention concerne des fils (ou " fibres ") de verre aptes à renforcer des matières organiques et/ou inorganiques et utilisables comme fils textiles, ces fils étant susceptibles d'être obtenus par le procédé qui consiste à étirer mécaniquement des filets de verre fondu s'écoulant d'orifices disposés à la base d'une filière généralement chauffée par effet Joule.

La présente invention vise plus précisément des fils de verre à faibles constantes diélectriques présentant une composition nouvelle particulièrement avantageuse pour former des fils fins.

On constate en effet une demande croissante de fils de verre dont la permittivité et les pertes diélectriques sont faibles, notamment pour former des tissus légers qui sont utilisés pour renforcer des supports de circuits imprimés. Ces supports sont constitués principalement d'un renfort, notamment des fils de verre, et d'une résine sur lesquels on dispose différents composants électriques et/ou électroniques.

Avec d'une part l'augmentation des vitesses de traitement des signaux électriques et/ou électroniques qui mettent en oeuvre des signaux de fréquences de plus en plus élevées, et d'autre part la miniaturisation des composants qui permet d'augmenter leur densité sur un support, les propriétés diélectriques de ce support deviennent déterminantes. Si ces propriétés n'ont pas les performances attendues, des risques de surchauffe et/ou de distorsion des signaux peuvent apparaître. Par ailleurs, pour contribuer à la miniaturisation, des fils de diamètre toujours plus faible sont recherchés pour diminuer l'épaisseur et améliorer la planéité des composants.

Les polymères utilisés traditionnellement pour les plaques de circuits imprimés sont essentiellement constitués de résine époxy. Des polymères présentant de meilleures propriétés diélectriques sont aujourd'hui connus, notamment les résines polyimide, les éthers de cyanate, les polyesters, voire le PTFE dont les propriétés diélectriques sont satisfaisantes.

L'amélioration des propriétés diélectriques d'une plaque de circuit imprimé doit donc essentiellement porter sur l'amélioration des propriétés du renfort représenté ici par les fils de verre selon la présente invention, qui occupent en général environ 60 % du volume.

Un verre soumis à un courant alternatif transforme une partie de celui-ci en énergie électrique dissipée dans le matériau. Cette énergie électrique est connue sous le nom de pertes diélectriques. Les pertes diélectriques sont proportionnelles à la permittivité et à la tangente de l'angle de perte (tan δ) qui dépendent de la composition du verre pour une fréquence donnée. Les pertes diélectriques sont données par la formule (voir par exemple : J.C. Dubois, dans " Techniques de l'Ingénieur " ; traité Electronique ; chapitre E 1850 ; Propriétés diélectriques des polymères) :

$$W = k \cdot f \cdot v^2 \cdot \varepsilon \cdot \tan \delta$$

où : W est l'énergie électrique dissipée dans le verre ou pertes diélectriques,

k    est une constante,
f    est la fréquence,
v    est un gradient de potentiel,
ε    est la permittivité et

tan δ est la tangente de l'angle de perte diélectrique ou facteur de dissipation diélectrique.

On note usuellement $\varepsilon \cdot \tan \delta = \varepsilon''$, si tan δ < 0,1.

Il apparaît clairement de cette formule que plus la fréquence augmente, ou plus ε et/ou tan δ augmentent, plus les pertes diélectriques deviennent importantes.

Dans la suite du texte, on nomme " propriétés diélectriques " le couple (ε, ε''). Afin de minimiser les distorsions d'un signal, on souhaite à la fois que ε et ε'' soient les plus faibles possibles.

Il est donc important d'obtenir des compositions de verre, aptes à être fibrées, notamment dans les conditions du procédé déjà mentionné, pour former des fils de renfort continus ayant des propriétés diélectriques et un diamètre compatibles avec les exigences des nouveaux circuits imprimés.

Plus précisément on note une tendance à l'augmentation des fréquences d'utilisation des composants, avec des domaines de fréquence de l'ordre du GHz (Giga Herz), notamment 0,9 et 1,8 GHz pour la téléphonie.

Il est donc très important d'étudier le comportement des fils de verre dans cette gamme de fréquence et d'optimiser leur composition afin de limiter les pertes diélectriques notamment pour ce domaine d'application.

Il convient de noter que la grande majorité des études antérieures publiées dans ce domaine traitent des propriétés diélectriques des verres dans une gamme de fréquence de l'ordre du MHz (Méga Herz).

La présente invention a pour objectif de proposer de nouvelles compositions de verre pour former des fils de renforcement qui présentent des propriétés diélectriques du même ordre de grandeur que celles des verres connus dans la gamme du MHz et qui simultanément présentent des propriétés diélectriques améliorées dans la gamme du GHz pour un diamètre de fil plus faible, tout en ayant des propriétés de fibrage satisfaisantes pour obtenir des fils de renforcement dans des conditions économiques.

En outre, il est souhaitable que les fils de verre en question puissent être fibrés dans des conditions occasionnant le moins de casse possible.

Dans la suite de l'invention on définit :

→ les propriétés diélectriques comme étant pour la "gamme du MHz " une gamme de fréquence où sont effectuées les caractérisations des propriétés diélectriques des verres, notamment à 1 MHz, et pour la "gamme du GHz ", une gamme de fréquence où sont effectuées les caractérisations des propriétés diélectriques des verres, notamment à 9,5 GHz.

→ les propriétés de fibrage déterminées notamment par :

- la température correspondant à une viscosité égale à $10^3$ Poises (déciPascal seconde, dPa.s), notée " T(log $\eta$ = 3) ", qui donne une indication précieuse sur la température autour de laquelle s'effectue généralement le fibrage notamment à partir de filières en platine ;
- la température de liquidus, notée " $T_{liq}$ ", qui correspond à la température où la vitesse de croissance du cristal le plus réfractaire est nulle. La température de liquidus donne la limite supérieure de zone de température où le verre peut avoir tendance à dévitrifier.

On considère qu'il est possible de fibrer le verre dans des conditions économiques si T(log $\eta$ = 3) est inférieur ou égal à 1350°C et si $T_{liq}$ est inférieur de plus de 100°C, de préférence de plus de 300°C à T(log $\eta$ = 3). Plus cet écart entre T(log $\eta$) = 3) et $T_{liq}$ est grand, plus le fibrage est susceptible de se dérouler sans incident, et plus on minimise les risques de casse au fibrage.

Les fils de verre de renforcement les plus couramment utilisés sont ainsi les fils formés de verres qui dérivent de l'eutectique à 1170°C du diagramme ternaire $SiO_2$-$Al_2O_3$-CaO, en particulier les fils désignés sous le nom de fils de verre E, dont l'archétype est décrit dans les brevets US-A-2 334 981 et US-A-2 571 074. Les fils de verre E présentent une composition essentiellement à base de silice, d'alumine, de chaux et d'anhydride borique. L'anhydride borique, présent à des taux allant en pratique de 5 à 13 % en poids dans les compositions de verres qualifiés " verre E ", remplace une partie de la silice. Les fils de verre E se caractérisent en outre par une teneur en oxydes alcalins (essentiellement $Na_2O$ et/ou $K_2O$) limitée. Si leur aptitude au fibrage est bonne (T(log $\eta$ = 3) de l'ordre de 1200°C et $T_{liq}$ de l'ordre de 1080°C), en revanche leurs propriétés diélectriques s'avèrent insuffisantes au regard des exigences nouvelles pour les supports de circuits imprimés.

Une autre famille de fils de verre est connue et obtenue à partir de compositions très riches en silice et en bore. Les verres de cette famille, connus sous l'appellation " verres D " comprennent environ 75 % de $SiO_2$, 20 % de $B_2O_3$, 3 % d'alcalins. Si ces verres sont intéressants pour leurs propriétés diélectriques, ils sont aussi très difficiles à fibrer (T(log $\eta$ = 3) $\geq$ 1400°C) en particulier lorsque les fils à obtenir sont fins (diamètre des filaments $\leq$ 10 $\mu$m). Le rendement de ce type de fils est faible (taux de casse élevé) et donc leur production est particulièrement onéreuse.

De nouvelles familles de compositions ont été récemment proposées qui permettent d'obtenir des propriétés diélectriques intéressantes et des conditions de fibrage relativement économiques. Ces compositions sont notamment décrites dans les demandes WO-A-96/39363 et WO-A-99/52833.

Ces compositions, bien que présentant des pertes diélectriques acceptables dans la gamme du MHz et du GHz, ne sont pas satisfaisantes pour former des fils fins car le taux de casse lors du fibrage reste élevé.

Une autre famille de compositions encore proposée récemment est décrite dans FR-A-2 825 084. Ces compositions sont aptes à donner des fils de renforcement dans des conditions de fibrage satisfaisantes économiquement et permettent d'atteindre de bonnes performances diélectriques dans la gamme du GHz. Il semble que le niveau élevé de performances soit dû à la présence de $P_2O_5$ dans les compositions.

Si l'ajout de $P_2O_5$ s'avère bénéfique pour les propriétés diélectriques, il augmente aussi le risque de démixtion avec pour conséquence la formation d'un verre hétérogène qui se casse plus facilement lors du fibrage.

Il a maintenant été trouvé que l'ajout d'oxyde de zirconium, $ZrO_2$, dans une composition fondée sur la combinaison $SiO_2$-$Al_2O_3$-$B_2O_3$ permet d'obtenir des fils de faible diamètre, notamment inférieur ou égal à 10 $\mu$m, de préférence inférieur ou égal à 7 $\mu$m, voire de l'ordre de 5 $\mu$m, dans de bonnes conditions de fibrage avec un taux de casse réduit, tout en conservant des propriétés diélectriques acceptables dans la gamme du MHz et du GHz.

Ainsi, les fils de verre selon l'invention sont obtenus à partir d'une composition comprenant essentiellement les constituants suivants, dans les limites définies ci-après, exprimés en pourcentages pondéraux :

| | |
|---|---|
| SiO$_2$ | 50 à 60 % |
| Al$_2$O$_3$ | 10 à 19 % |
| B$_2$O$_3$ | 16 à 25 % |
| ZrO$_2$ | 0,5 à 1,5% |
| Na$_2$O | inférieur ou égal à 1,5 % |
| K$_2$O | inférieur ou égal à 1,5 % |
| R$_2$O (Na$_2$O + K$_2$O + Li$_2$O) | inférieur ou égal à 2 % |
| CaO | inférieur ou égal à 10 % |
| MgO | inférieur ou égal à 10 % |
| RO (CaO + MgO) | 4 à 15 % |
| F | 0 à 2% |
| TiO$_2$ | 0 à 3 % |
| Divers | inférieur ou égal à 3 % |

Les compositions selon l'invention permettent d'obtenir des propriétés de fibrage satisfaisantes et avantageuses, permettant de procéder à un fibrage économique, notamment grâce à T(log η = 3) ≤ 1350°C.

Les compositions selon l'invention présentent une température de liquidus acceptable, notamment inférieure ou égale à 1150°C, sans risque majeur de dévitrification lors du fibrage dans des zones froides du creuset de fibrage et dans les canaux conduisant le verre du four aux creusets de fibrage.

La silice est l'un des oxydes qui forme le réseau des verres selon l'invention et joue un rôle essentiel pour leur stabilité.

Le taux de silice, SiO$_2$, des compositions sélectionnées est compris entre 50 et 60 %, notamment supérieur à 52 %, et/ou notamment inférieur ou égal à 57 %.

L'alumine, Al$_2$O$_3$, constitue également un formateur du réseau des verres selon l'invention et joue un rôle très important à l'égard de la résistance hydrolytique de ces verres. Dans le cadre des limites définies selon l'invention, la diminution du pourcentage de cet oxyde en dessous de 10 % entraîne une augmentation sensible de l'attaque hydrolytique du verre tandis qu'une trop forte augmentation du pourcentage de cet oxyde entraîne des risques de dévitrification et une augmentation de la viscosité.

Le taux d'Al$_2$O$_3$ des compositions sélectionnées est compris entre 10 et 19 %, notamment supérieur ou égal à 13 % et/ou notamment inférieur ou égal à 17 %.

Le taux de chaux, CaO, des compositions sélectionnées est inférieur ou égal à 10 %, notamment inférieur ou égal à 8 %, voire même inférieur ou égal à 6 % et/ou de préférence supérieur ou égal à 2 %, voire même supérieur ou égal à 4 %.

Le taux de magnésie, MgO, des compositions sélectionnées est inférieur ou égal à 10 %, notamment inférieur ou égal à 8 %, voire même inférieur ou égal à 6 % et/ou de préférence supérieur ou égal à 2 %.

L'adjonction d'oxyde de zirconium, ZrO$_2$, apparaît être un point essentiel de l'invention. Le taux de ZrO$_2$ est compris entre 0,5 et 1,5 %, de préférence est inférieur ou égal à 1 %. Cet oxyde apparaît jouer un rôle très important sur les propriétés diélectriques, plus particulièrement dans la gamme du GHz comme indiqué par la suite dans les exemples. Cependant, la teneur doit être limitée à 1,5% pour éviter une augmentation inacceptable de la température de liquidus.

Les limites définies en oxydes alcalino-terreux, chaux et magnésie, permettent de régler la viscosité des verres selon l'invention. Une bonne aptitude au fibrage est obtenue en choisissant la somme de ces oxydes alcalino-terreux comprise entre 4 et 15 %, de préférence supérieure ou égale à 6 % et/ou de préférence inférieure ou égale à 10 %.

En outre CaO apparaît avoir une contribution bénéfique sur la résistance hydrolytique.

Des alcalins, notamment Na$_2$O et K$_2$O peuvent être introduits dans les compositions des fils de verre selon l'invention pour limiter la dévitrification et réduire éventuellement la viscosité du verre. La teneur en oxydes alcalins Na$_2$O + K$_2$O + Li$_2$O doit cependant rester inférieure ou égale à 2 % pour éviter une détérioration des propriétés diélectriques et une diminution pénalisante de la résistance hydrolytique du verre. Le taux d'alcalins est généralement supérieur à 0,1 %, dû à la présence d'impuretés contenues dans les matières premières porteuses d'autres constituants et il est de préférence inférieur ou égal à 1 %, voire à 0,5 %, voire même à 0,3 %. La composition peut contenir un seul oxyde alcalin (parmi Na$_2$O, K$_2$O et Li$_2$O) ou peut contenir une combinaison d'au moins deux oxydes alcalins, la teneur de chaque alcalin étant inférieure ou égale à 1,5 %, de préférence inférieure ou égale à 0,8 %.

Le taux de bore est compris entre 16 et 25 %, de préférence supérieur ou égal à 18 % et/ou de préférence inférieur ou égal à 22 %, voire inférieur ou égal à 20 %. Selon une version préférée de l'invention, on souhaite limiter cet oxyde à des teneurs modérées par rapport à celles du verre D d'une part pour ne pas dégrader la résistance hydrolytique et d'autre part car le prix des matières premières porteuses de bore est élevé. Du bore peut être introduit en quantité modérée par l'incorporation, comme matière première, de déchets de fils de verre comprenant du bore, par exemple des fils de verre E.

Du fluor, F, peut être ajouté en faible quantité pour améliorer la fusion du verre notamment de 0,5 à 2 %, ou être présent à l'état d'impureté, notamment de 0,1 à 0,5 %.

De l'oxyde de titane, $TiO_2$, peut également être introduit en quantité pouvant représenter jusqu'à 3 % de la composition, de préférence inférieure à 2 %, voire inférieure à 1%. Il permet d'abaisser la viscosité sans dégradation notable des pertes diélectriques.

La teneur éventuelle en $Fe_2O_3$ est plutôt à considérer comme une teneur en impuretés, fréquemment rencontrées dans cette famille de compositions.

Dans la suite du texte, tout pourcentage d'un constituant de la composition doit se comprendre comme un pourcentage pondéral, et les compositions selon l'invention peuvent comporter jusqu'à 2 ou 3 % de composés à considérer comme des impuretés non analysées (par exemple $SrO$, $SO_3$, $MnO$, $MnO_2$), comme cela est connu dans ce genre de composition. L'invention concerne également des composites formés de fils de verre et de matière organique où le renforcement est assuré au moins par les fils de verre de compositions définies ci-dessus.

De manière préférée, de tels fils de verre sont utilisés pour la fabrication de support de circuits imprimés, notamment pour former des tissus légers composés de fils de diamètre inférieur ou égal à 10 $\mu$m, de préférence inférieur ou égal à 7 $\mu$m, et avantageusement de l'ordre de 5 $\mu$m.

L'invention concerne également un procédé de fabrication de fils de verre de compositions définies ci-dessus selon lequel on étire une multiplicité de filets de verre fondu, s'écoulant d'une multiplicité d'orifices disposés à la base d'une ou plusieurs filières, sous la forme d'une ou plusieurs nappes de filaments continus, puis on rassemble les filaments en un ou plusieurs fils que l'on collecte sur un support en mouvement.

De manière préférée, le verre fondu alimentant les orifices de la ou des filières présente la composition suivante, exprimée en pourcentages pondéraux :

| | |
|---|---|
| $SiO_2$ | 50 à 60%, de préférence $SiO_2 \geq 52$ % et/ou $SiO_2 \leq 57$ % |
| $Al_2O_3$ | 10 à 19 %, de préférence $Al_2O_3 \geq 13$% et/ou $Al_2O_3 \geq 17$ % |
| $B_2O_3$ | 16 à 25 % |
| $ZrO_2$ | 0,5 à 1,5 % |
| $Na_2O$ | $\leq 0,8$ % |
| $K_2O$ | $\leq 0,8$ % |
| $R_2O$ | $\leq 1$% |
| $CaO$ | $\leq 10$% |
| $MgO$ | $\leq 10$% |
| $F$ | 0 à 2 % |
| $TiO_2$ | 0 à 3% |
| $RO$ | 4 à 15 %, de préférence $RO \geq 6$ % et/ou $RO \leq 10$ % |
| Divers | $\leq 3$ %, |

où $R_2O = Na_2O + K_2O + Li_2O$, et $RO = CaO + MgO$

On peut ainsi fabriquer de tels fils de verre de faible diamètre dans des conditions de mise en oeuvre intermédiaires entre celles du verre E et du verre D et obtenir de manière particulièrement économique des verres à bonnes propriétés diélectriques.

L'invention concerne également des compositions de verre adaptées à la réalisation de fils de verre de renforcement comprenant les constituants suivants, dans les limites définies ci-après exprimées en pourcentages pondéraux :

| | |
|---|---|
| $SiO_2$ | 50 à 60 %, de préférence $SiO_2 \geq 52$ % et/ou $SiO_2 \leq 57$ % |
| $Al_2O_3$ | 10 à 19 %, de préférence $Al_2O_3 \geq 13$% et/ou $Al_2O_3 \leq 17$% |
| $B_2O_3$ | 16 à 25 % |
| $ZrO_2$ | 0,5 à 1,5 % |
| $Na_2O$ | $\leq 1,5$%, de préférence $Na_2O \leq 0,8$ % |
| $K_2O$ | $\leq 1,5$ %, de préférence $K_2O \leq 0,8$ % |
| $R_2O$ | $\leq 2$ %, de préférence $R_2O \leq 1$ % |
| $CaO$ | $\leq 10$% |

(suite)

| | | |
|---|---|---|
| MgO | $\leq 10\%$ | |
| F | 0 à 2 % | |
| $TiO_2$ | 0 à 3% | |
| RO | 4 à 15%, de préférence RO $\geq$ 6% et/ou RO $\leq$ 10 % | |
| Divers | $\leq$ 3 %, | |

où $R_2O = Na_2O + K_2O + Li_2O$, et $RO = CaO + MgO$

Les avantages présentés par les fils de verre selon l'invention seront mieux appréciés à travers les exemples suivants notés Ex. 1 et Ex. 2 donnés dans le tableau 1 qui illustrent la présente invention sans toutefois la limiter.

Des exemples comparatifs notés A, et B figurent également dans le tableau 1. Ils correspondent aux verres suivants :

A :    verre D

B :    verre selon la demande de brevet WO 99/52833

Dans ces exemples, des fils composés de filaments de verre ayant un diamètre de 7 $\mu$m (exemples 1, 2 et B) et de 10 $\mu$m (exemple A) sont obtenus par étirage de verre fondu, le verre présente la composition mentionnée dans le tableau 1, exprimée en pourcentages pondéraux.

Quand la somme totale des teneurs de l'ensemble des composés est légèrement inférieure ou supérieure à 100 %, il faut comprendre que le taux résiduel correspond aux impuretés, composants minoritaires non analysés (taux d'au plus 1 à 2 %) et/ou est dû à l'approximation acceptée dans ce domaine dans les méthodes d'analyse utilisées.

On note T(log $\eta$ = 3) la température à laquelle la viscosité du verre est de $10^3$ Poises (déciPascal seconde, dPa.s).

On note $T_{liq}$ la température de liquidus du verre, correspondant à la température à laquelle la phase la plus réfractaire, qui peut dévitrifier dans le verre, a une vitesse de croissance nulle et correspond ainsi à la température de fusion de cette phase dévitrifiée.

On reporte les écarts des valeurs des propriétés diélectriques ($\Delta\varepsilon$, $\Delta\varepsilon''$) mesurées à la fois à 1 MHz et à 9,5 GHz par rapport à la référence A (verre D).

Les mesures à 1 MHz sont effectuées de manière traditionnelle, connue de l'homme du métier pour ce type de métrologie.

Les mesures à 9,5 GHz ont été effectuées suivant la méthode décrite par W.B. Westphal (" Distributed Circuits ", dans "Dielectric materials and applications ", the Technology Press of MIT and John Wiley & Sons, Inc. New York, Chapman & Hall, Ltd, London, 1954. Voir notamment p. 69). Le principe de cette méthode est basé sur la mesure des propriétés diélectriques d'un échantillon sous forme de disque, disposé contre un guide d'onde. Cette méthode permet d'obtenir des' résultats précis à très haute fréquence. Dans le tableau 1 figure également le nombre de bobines de fil complètes formées par jour dans les conditions mentionnées précédemment. Ce nombre permet d'avoir une mesure d'appréciation du rendement de fibrage comparable pour les différents verres.

Il apparaît que les exemples selon l'invention présentent un compromis remarquable entre les conditions de fibrage (taux de casse, température de fbrage (Tlog $\eta$ = 3) et $T_{liq}$) et les propriétés diélectriques.

La plage de fibrage est satisfaisante, notamment avec un écart entre T(log $\eta$ = 3) et $T_{liq}$ supérieur ou égal à 180°C.

Les propriétés diélectriques des compositions selon l'invention sont du même ordre de grandeur que celles des compositions selon WO 99/52833 pour des mesures à 1 MHz et à 9,5 GHz.

On se rapproche de manière remarquable des propriétés diélectriques du verre D, tout en abaissant la température de fibrage des verres selon l'invention en comparaison avec celle du verre D.

Les verres selon l'invention sont remarquables encore en ce qu'ils permettent de former des fils de faible diamètre avec un rendement particulièrement avantageux. Ainsi, le nombre de bobines complètes de fil est meilleur avec les verres selon l'invention qu'avec les verres selon WO 99/52833 (+ 36 %) pour un diamètre de filaments identique, et considérablement plus élevé (+ 300 %) qu'avec le verre D, et ce pour un diamètre bien plus faible (7 $\mu$m au lieu de 10 $\mu$m).

Les fils de verre selon l'invention conviennent avantageusement pour toutes les applications habituelles des fils de verre E classiques et peuvent être substitués à des fils de verre D pour certaines applications. En particulier, les fils de verre selon l'invention présentent l'avantage de pouvoir être obtenus avec un meilleur rendement et un coût moindre que les fils de verre connus.

Grâce à leur finesse et donc à leur masse linéique faible, les fils de verre selon l'invention sont utiles pour former des tissus légers présentant une bonne planéité, particulièrement recherchée dans les applications électroniques.

TABLEAU 1

|  | Exemple 1 | Exemple 2 | A | B |
|---|---|---|---|---|
| $SiO_2$ | 55,7 | 54,7 | 75,3 | 54,7 |
| $Al_2O_3$ | 15 | 15,0 | 0,7 | 15,0 |
| $B_2O_3$ | 19,4 | 19,0 | 19,6 | 19,9 |
| $Na_2O$ |  |  | 1,8 |  |
| $K_2O$ |  |  | 1,2 |  |
| $R_2O$ | 0,3 | 0,3 | 3,0 | 0,3 |
| CaO | 4,1 | 4,0 | 0,8 | 4,0 |
| MgO | 4,1 | 4,0 | 0,4 | 4,0 |
| $TiO_2$ |  | 1,6 |  | 2,5 |
| $ZrO_2$ | 0,9 | 0,9 |  |  |
| F | 0,5 | 0,5 |  | 0,5 |
| $T(\log \eta = 3)$ (°C) | 1343 | 1330 | 1410 | 1310 |
| $T_{liq}$ (°C) | 1150 | 1150 | < 900 | 1060 |
| $\Delta\varepsilon$ à 1 MHz | + 0,4 | + 0,4 | - | + 0,6 |
| $\Delta\varepsilon''$ à 1 MHz ($\times 10^4$) | 0 | 0 | - | 0 |
| $\Delta\varepsilon$ à 9,5 GHz | +0,5 | +0,6 | - | + 0,6 |
| $\Delta\varepsilon''$ à 9,5 GHz ($\times 10^4$) | +150 | + 160 | - | + 120 |
| Nombre de bobines complètes | 30 | 30 | 10 | 22 |

**Revendications**

1. Fil de verre de renforcement dont la composition comprend les constituants suivants, dans les limites définies ci-après, exprimées en pourcentages pondéraux :

| | |
|---|---|
| $SiO_2$ | 50 à 60 %, de préférence $SiO_2 \geq 52$ % et/ou $SiO_2 \leq 57$ % |
| $Al_2O_3$ | 10 à 19 %, de préférence $Al_2O_3 \geq 13$ % et/ou $Al_2O_3 \leq 17$% |
| $B_2O_3$ | 16 à 25 % |
| $ZrO_2$ | 0,5 à 1,5 % |
| $Na_2O$ | $\leq 1,5$ %, de préférence $Na_2O \leq 0,8$ % |
| $K_2O$ | $\leq 1,5$ %, de préférence $K_2O \leq 0,8$ % |
| $R_2O$ | $\leq 2$ %, de préférence $R_2O \leq 1$ % |
| CaO | $\leq 10$ % |
| MgO | $\leq 10$ % |
| F | 0 à 2 % |
| $TiO_2$ | 0 à 3% |
| RO | 4 à 15 %, de préférence $RO \geq 6$ % et/ou $RO \leq 10$ % |
| Divers | $\leq 3$ %, |

où $R_2O = Na_2O + K_2O + Li_2O$, et $RO = CaO + MgO$

2. Fil de verre selon la revendication 1, **caractérisé en ce que** la composition comprend un taux de $ZrO_2$ tel que $ZrO_2 \leq 1$ %.

3. Fil de verre selon l'une des revendications précédentes, **caractérisé en ce que** la composition comprend un taux de chaux CaO tel que $CaO \leq 8$ %, voire $CaO \leq 6$ % et/ou $CaO \geq 2$ %, voire $CaO \geq 4$ %.

4. Fil de verre selon l'une des revendications précédentes, **caractérisé en ce que** la composition comprend un taux de magnésie MgO tel que $MgO \leq 8$%, voire $MgO \leq 6$ % et/ou $MgO \geq 2$ %.

7

**5.** Fil de verre selon l'une des revendications précédentes, **caractérisé en ce que** la composition comprend un taux de bore $B_2O_3$ tel que $B_2O_3 \geq 18\%$ et/ou $B_2O_3 \leq 22\%$, voire $B_2O_3 \leq 20\%$.

**6.** Composite de fils de verre et de matière(s) organique(s) et/ou inorganique(s), **caractérisé en ce qu'**il comprend des fils de verre tels que définis par l'une des revendications 1 à 5.

**7.** Utilisation des fils de verre définis par l'une des revendications 1 à 5 pour la fabrication de support de circuits imprimés.

**8.** Procédé de fabrication de fils de verre tels que définis dans l'une des revendications 1 à 5, selon lequel on étire une multiplicité de filets de verre fondu, s'écoulant d'une multiplicité d'orifices disposés à la base d'une ou plusieurs filières, sous la forme d'une ou plusieurs nappes de filaments continus, puis on rassemble les filaments en un ou plusieurs fils que l'on collecte sur un support en mouvement.

**9.** Procédé selon la revendication 8, **caractérisé en ce que** le verre fondu alimentant les orifices de la ou des filières présente la composition suivante, exprimée en pourcentages pondéraux :

| | |
|---|---|
| $SiO_2$ | 50 à 60 %, de préférence $SiO_2 \geq 52\%$ et/ou $SiO_2 \leq 57\%$ |
| $Al_2O_3$ | 10 à 19 %, de préférence $Al_2O_3 \geq 13\%$ et/ou $Al_2O_3 \leq 17\%$ |
| $B_2O_3$ | 16 à 25 % |
| $ZrO_2$ | 0,5 à 1,5 % |
| $Na_2O$ | $\leq 1,5\%$, de préférence $Na_2O \leq 0,8\%$ |
| $K_2O$ | $\leq 1,5\%$, de préférence $K_2O \leq 0,8\%$ |
| $R_2O$ | $\leq 2\%$, de préférence $R_2O \leq 1\%$ |
| CaO | $\leq 10\%$ |
| MgO | $\leq 10\%$ |
| F | 0 à 2 % |
| $TiO_2$ | 0 à 3% |
| RO | 4 à 15 %, de préférence $RO \geq 6\%$ et/ou $RO \leq 10\%$ |
| Divers | $\leq 3\%$, |

où $R_2O = Na_2O + K_2O + Li_2O$, et $RO = CaO + MgO$

**10.** Composition de verre adaptée à la réalisation de fils de verre de renforcement comprenant les constituants suivants, dans les limites définies ci-après exprimées en pourcentages pondéraux :

| | |
|---|---|
| $SiO_2$ | 50 à 60%, de préférence $SiO_2 \geq 52\%$ et/ou $SiO_2 \leq 57\%$ |
| $Al_2O_3$ | 10 à 19 %, de préférence $Al_2O_3 \geq 13\%$ et/ou $Al_2O_3 \leq 17\%$ |
| $B_2O_3$ | 16 à 25% |
| $ZrO_2$ | 0,5 à 1,5 % |
| $Na_2O$ | $\leq 1,5\%$, de préférence $Na_2O \leq 0,8\%$ |
| $K_2O$ | $\leq 1,5\%$, de préférence $K_2O \leq 0,8\%$ |
| $R_2O$ | $\leq 2\%$, de préférence $R_2O \leq 1\%$ |
| CaO | $\leq 10\%$ |
| MgO | $\leq 10\%$ |
| F | 0 à 2 % |
| $TiO_2$ | 0 à 3% |
| RO | 4 à 15 %, de préférence $RO \geq 6\%$ et/ou $RO \leq 10\%$ |
| Divers | $\leq 3\%$, |

où $R_2O = Na_2O + K_2O + Li_2O$, et $RO = CaO + MgO$

**Claims**

1.  A glass reinforcement strand, the composition of which comprises the following constituents, within the limits defined below, expressed as percentages by weight:

    | | |
    |---|---|
    | $SiO_2$ | 50 to 60%, preferably $SiO_2 \geq 52\%$ and/or $SiO_2 \leq 57\%$; |
    | $Al_2O_3$ | 10 to 19%, preferably $Al_2O_3 \geq 13\%$ and/or $Al_2O_3 \leq 17\%$; |
    | $B_2O_3$ | 16 to 25 % ; |
    | $ZrO_2$ | 0.5 to 1.5%; |
    | $Na_2O$ | $\leq 1.5\%$, preferably $Na_2O \leq 0.8\%$; |
    | $K_2O$ | $\leq 1.5\%$, preferably $K_2O \leq 0.8\%$; |
    | $R_2O$ | $\leq 2$ %, preferably $R_2O \leq 1\%$; |
    | CaO | $\leq 10\%$; |
    | MgO | $\leq 10\%$; |
    | F | 0 to 2%; |
    | $TiO_2$ | 0 to 3%; |
    | RO | 4 to 15%, preferably $RO \geq 6\%$ and/or $RO \leq 10\%$; and |
    | Various | $\leq 3\%$, |

    where $R_2O = Na_2O + K_2O + Li_2O$, and $RO = CaO + MgO$.

2.  The glass strand as claimed in claim 1, **characterized in that** the composition has a $ZrO_2$ content such that $ZrO_2 \leq 1\%$.

3.  The glass strand as claimed in one of the preceding claims, **characterized in that** the composition has a lime (CaO) content such that $CaO \leq 8\%$, or even $CaO \leq 6\%$ and/or $CaO \geq 2\%$, or even $CaO \geq 4\%$.

4.  The glass strand as claimed in one of the preceding claims, **characterized in that** the composition has a magnesia (MgO) content such that $MgO \leq 8\%$, or even $MgO \leq 6\%$ and/or $MgO \geq 2\%$.

5.  The glass strand as claimed in one of the preceding claims, **characterized in that** the composition has a boron ($B_2O_3$) content such that $B_2O_3 \geq 18\%$ and/or $B_2O_3 \leq 22\%$, or even $B_2O_3 \leq 20\%$.

6.  A composite of glass strands and organic and/or inorganic material(s), **characterized in that** it comprises glass strands as defined by one of claims 1 to 5.

7.  The use of the glass strands defined by one of claims 1 to 5 for the manufacture of printed-circuit substrates.

8.  A process for manufacturing glass strands as defined in one of claims 1 to 5, in which a multiplicity of molten glass streams, flowing out of a multiplicity of orifices located at the base of one or more bushings, is drawn in the form of one or more webs of continuous filaments and then the filaments are gathered together into one or more strands which are collected on a moving support.

9.  The process as claimed in claim 8, **characterized in that** the molten glass feeding the orifices of the bushing or bushings has the following composition, expressed as percentages by weight:

    | | |
    |---|---|
    | $SiO_2$ | 50 to 60%, preferably $SiO_2 \geq 52\%$ and/or $SiO_2 \leq 57\%$; |
    | $Al_2O_3$ | 10 to 19%, preferably $Al_2O_3 \geq 13\%$ and/or $Al_2O_3 \leq 17\%$; |
    | $B_2O_3$ | 16 to 25%; |
    | $ZrO_2$ | 0.5 to 1.5%; |
    | $Na_2O$ | $\leq 1.5\%$, preferably $Na_2O \leq 0.8\%$; |
    | $K_2O$ | $\leq 1.5\%$, preferably $K_2O \leq 0.8\%$; |
    | $R_2O$ | $\leq 2\%$, preferably $R_2O \leq 1\%$ ; |
    | CaO | $\leq 10\%$; |
    | MgO | $\leq 10\%$; |
    | F | 0 to 2%; |

(continued)

| | |
|---|---|
| TiO$_2$ | 0 to 3%; |
| RO | 4 to 15%, preferably RO $\geq$ 6% and/or RO $\leq$ 10%; and |
| Various | $\leq$ 3%, |

where R$_2$O = Na$_2$O + K$_2$O + Li$_2$O, and RO = CaO + MgO.

**10.** A glass composition suitable for producing glass reinforcement strands, comprising the following constituents, within the limits defined below, expressed as percentages by weight:

| | |
|---|---|
| SiO$_2$ | 50 to 60%, preferably SiO$_2$ $\geq$ 52% and/or SiO$_2$ $\leq$ 57%; |
| Al$_2$O$_3$ | 10 to 19%, preferably Al$_2$O$_3$ $\geq$ 13% and/or Al$_2$O$_3$ $\leq$ 17%; |
| B$_2$O$_3$ | 16 to 25%; |
| ZrO$_2$ | 0.5 to 1.5%; |
| Na$_2$O | $\leq$ 1.5%, preferably Na$_2$O $\leq$ 0.8%; |
| K$_2$O | $\leq$ 1.5%, preferably K$_2$O $\leq$ 0.8%; |
| R$_2$O | $\leq$ 2%, preferably R$_2$O $\leq$ 1%; |
| CaO | $\leq$ 10%; |
| MgO | $\leq$ 10%; |
| F | 0 to 2%; |
| TiO$_2$ | 0 to 3%; |
| RO | 4 to 15%, preferably RO $\geq$ 6% and/or RO $\leq$ 10%; and |
| Various | $\leq$ 3%, |

where R$_2$O = Na$_2$O + K$_2$O + Li$_2$O, and RO = CaO + MgO.

**Patentansprüche**

**1.** Bewehrungsglasfaser, deren Zusammensetzung folgende Bestandteile innerhalb von in prozentualen Gewichtsanteilen angegebenen anschließend definierten Grenzen umfasst:

| | |
|---|---|
| SiO$_2$ | 50 bis 60 % und vorzugsweise SiO$_2$ $\geq$ 52 % und/oder SiO$_2$ $\leq$ 57 % |
| Al$_2$O$_3$ | 10 bis 19 % und vorzugsweise Al$_2$O$_3$ $\geq$ 13 % und/oder Al$_2$O$_3$ $\leq$ 17 % |
| B$_2$O$_3$ | 16 bis 25 % |
| ZrO$_2$, | 0,5 bis 1,5% |
| Na$_2$O | $\leq$ 1,5 % und vorzugsweise Na$_2$O $\leq$ 0,8 % |
| K$_2$O | $\leq$ 1,5 % und vorzugsweise K$_2$O $\leq$ 0,8 % |
| R$_2$O | $\leq$ 2 % und vorzugsweise R$_2$O $\leq$ 1 % |
| CaO | $\leq$ 10 % |
| MgO | $\leq$ 10 % |
| F | 0 bis 2 % |
| TiO$_2$ | 0 bis 3 % |
| RO | 4 bis 15 % und vorzugsweise RO $\geq$ 6 % und/oder RO $\leq$ 10% |
| verschiedene | $\leq$ 3 %, |

wobei R$_2$O = Na$_2$O + K$_2$O + Li$_2$O und RO = CaO + MgO.

**2.** Glasfaser nach Anspruch 1, **dadurch gekennzeichnet, dass** die Zusammensetzung einen derartigen Anteil an ZrO$_2$ enthält, dass ZrO$_2$ $\leq$ 1 %.

**3.** Glasfaser nach einem der vorhergehenden Ansprüche, **dadurch gekennzeichnet, dass** die Zusammensetzung einen derartigen Anteil an Calciumoxid, CaO, enthält, dass CaO $\leq$ 8 % und sogar CaO $\leq$ 6 % und/oder CaO $\geq$ 2 %

und sogar CaO ≥ 4%.

**4.** Glasfaser nach einem der vorhergehenden Ansprüche, **dadurch gekennzeichnet, dass** die Zusammensetzung einen derartigen Anteil an Magnesiumoxid, MgO, enthält, dass MgO ≤ 8 % und sogar MgO ≤ 6 % und/oder MgO ≥ 2 %.

**5.** Glasfaser nach einem der vorhergehenden Ansprüche, **dadurch gekennzeichnet, dass** die Zusammensetzung einen derartigen Anteil an Boroxid, $B_2O_3$, enthält, dass $B_2O_3$ ≥ 18% und/oder $B_2O_3$ ≤ 22 % und sogar $B_2O_3$ ≤ 20 %.

**6.** Verbundmaterial aus Glasfasern und einem oder mehreren organischen und/oder anorganischen Materialien, **dadurch gekennzeichnet, dass** es Glasfasern wie in einem der Ansprüche 1 bis 5 definiert enthält.

**7.** Verwendung der in einem der Ansprüche 1 bis 5 definierten Glasfasern zur Herstellung eines Trägers für gedruckte Schaltkreise.

**8.** Verfahren zur Herstellung von wie in einem der Ansprüche 1 bis 5 definierten Glasfasern, gemäß welchem eine Vielzahl von Glasstrahlen, die aus einer Vielzahl von Öffnungen fließen, die im Boden einer oder mehrerer Spinndüsen angeordnet sind, zur Form einer oder mehrerer Bahnen aus endlosen Filamenten gezogen wird und anschließend die Filamente zu einem oder mehreren Fäden vereinigt werden, die auf einem sich bewegenden Träger gesammelt werden.

**9.** Verfahren nach Anspruch 8, **dadurch gekennzeichnet, dass** die Glasschmelze, mit welcher die Öffnungen der Spinndüse(n) versorgt werden, folgende in prozentualen Gewichtsanteilen angegebene Zusammensetzung aufweist:

| | |
|---|---|
| $SiO_2$ | 50 bis 60 % und vorzugsweise $SiO_2$ ≥ 52 % und/oder $SiO_2$ ≤ 57 % |
| $Al_2O_3$ | 10 bis 19 % und vorzugsweise $Al_2O_3$ ≥ 13 % und/oder $Al_2O_3$ ≤ 17 % |
| $B_2O_3$ | 16 bis 25 % |
| $ZrO_2$ | 0,5 bis 1,5 % |
| $Na_2O$ | ≤ 1,5 % und vorzugsweise $Na_2O$ ≤ 0,8 % |
| $K_2O$ | ≤ 1,5 % und vorzugsweise $K_2O$ ≤ 0,8 % |
| $R_2O$ | ≤ 2 % und vorzugsweise $R_2O$ ≤ 1 % |
| CaO | ≤ 10% |
| MgO | ≤ 10 % |
| F | 0 bis 2 % |
| $TiO_2$ | 0 bis 3 % |
| RO | 4 bis 15 % und vorzugsweise RO ≥ 6 % und/oder RO ≤ 10% |
| verschiedene | ≤ 3 %, |

wobei $R_2O = Na_2O + K_2O + Li_2O$ und $RO = CaO + MgO$.

**10.** Glaszusammensetzung, die für die Herstellung von Bewehrungsglasfasern geeignet ist und folgende Bestandteile innerhalb der in prozentualen Gewichtsanteilen angegebenen anschließend definierten Grenzen umfasst:

| | |
|---|---|
| $SiO_2$ | 50 bis 60 % und vorzugsweise $SiO_2$ ≥ 52 % und/oder $SiO_2$ ≤ 57 % |
| $Al_2O_3$ | 10 bis 19 % und vorzugsweise $Al_2O_3$ ≥ 13 % und/oder $Al_2O_3$ ≤ 17 % |
| $B_2O_3$ | 16 bis 25 % |
| $ZrO_2$ | 0,5 bis 1,5% |
| $Na_2O$ | ≤ 1,5 % und vorzugsweise $Na_2O$ ≤ 0,8 % |
| $K_2O$ | ≤ 1,5 % und vorzugsweise $K_2O$ ≤ 0,8 % |
| $R_2O$ | ≤ 2 % und vorzugsweise $R_2O$ ≤ 1 % |
| CaO | ≤ 10 % |
| MgO | ≤ 10% |
| F | 0 bis 2% |
| $TiO_2$ | 0 bis 3% |
| RO | 4 bis 15 % und vorzugsweise RO ≥ 6 % und/oder RO ≤ 10% |

(fortgesetzt)

| verschiedene | $\leq 3\ \%$, |
| --- | --- |

wobei $R_2O = Na_2O + K_2O + Li_2O$ und $RO = CaO + MgO$.